# EUROPEAN PATENT APPLICATION

(11) **EP 4 435 870 A1**
(43) Date of publication of application: **25.09.2024**
(21) Application number: 24162883.3
(22) Date of filing: 12.03.2024
(51) Int. Cl.: H01L 29/40, G03F 7/00, H01L 21/335, H01L 29/778, H01L 23/31, H01L 29/10, H01L 29/20

(54) **NORMALLY-OFF HETEROJUNCTION INTEGRATED DEVICE AND METHOD FOR MANUFACTURING AN INTEGRATED DEVICE**

(30) Priority: 13.03.2023 IT 202300004668
(71) Applicant: STMicroelectronics International N.V., 1228 Plan-les-Ouates, Geneva (CH)
(72) Inventor: MICCOLI, Cristina, 95030 TREMESTIERI ETNEO (CT) (IT); IUCOLANO, Ferdinando, 95030 GRAVINA DI CATANIA (CT) (IT); TRINGALI, Cristina, 96011 AUGUSTA (SR) (IT); CASTAGNA, Maria Eloisa, 95123 CATANIA (IT); CHINI, Alessandro, 41126 MODENA (IT)
(74) Representative: Studio Torta S.p.A.

(57) **Abstract**

An integrated power device includes a heterostructure (10), having a channel layer (2) and a barrier layer (3), a source contact (7), a drain contact (8), a gate region (5) and a gate contact (9) on the gate region (5). An insulating gate structure (15)has a first insulating gate portion (15a) and a second insulating gate portion (15b), which extend in a conformable way along sides (5a, 9a) of the gate region (5) and of the gate contact (9) that face the drain contact (8). An insulating field structure (13), having a first dielectric region (13a) on the barrier layer (3) and a second dielectric region (13b) selectively etchable with respect to the first dielectric region (13a), is arranged on the barrier layer (3) between the gate region (5) and the drain contact. A source field plate (12) extends over the insulating field structure (13). On a side of the insulating field structure (13) towards the gate region (5), the source field plate (12) is in contact with the first dielectric region (13a). The source field plate is in contact with the second insulating gate portion (15b; 115b; 215b) along the sides (5a, 9a).

## Description

### TECHNICAL FIELD

The present invention relates to a normally-off heterojunction integrated device and to a method for manufacturing an integrated device.

### CONTEXT

As is known, heterostructures comprise contiguous layers or regions of materials, generally semiconductor materials, that have different bandgaps and define heterojunctions at the respective interfaces, where, on the basis of the physical and structural properties of the materials constituting the heterojunction, a two-dimensional electron gas (2DEG) may be formed. Some heterostructures are of great interest in the manufacture of field-effect transistors owing both to their breakdown resistance and to the density and mobility of the charge carriers in the proximity of the heterojunctions. For instance, AlGaN/GaN (aluminum and gallium nitride/gallium nitride) heterostructures are increasingly used for producing high-electron-mobility transistors (HEMTs) for high-power and high-frequency applications. The two-dimensional electron gas is in fact formed in an intrinsic region of the material having the narrower bandgap.

AlGaN/GaN HEMTs are in general of the normally on type, but, to guarantee proper operation and simplify the driving circuits, in many practical applications it is convenient to use also AlGaN/GaN HEMTs of the normally-off type. Different techniques are known for manufacturing normally-off AlGaN/GaN HEMTs. Amongst these, the so-called "p-GaN gate" technique is used on a commercial scale and entails formation of a p-doped GaN region on an AlGaN/GaN heterostructure, which comprises a GaN channel layer and an AlGaN barrier layer that define a heterojunction. The p-doped GaN region, or p-GaN gate region, is formed between the heterostructure and the gate electrode.

The solution is functionally correct, since it defines to all effects normally-off HEMTs; however, the performance may not be satisfactory, in particular in terms of maximum operating frequency. The limits are mainly due to the gate-to-drain capacitance and to the charge that it is consequently necessary to remove or inject for completing switching of the devices. There is therefore felt the need for devices of the normally-off type that will have a higher switching speed and will thus be usable for applications at higher frequencies.

### SUMMARY

The aim of the present invention is to provide an integrated power device and a method for manufacturing an integrated power device that will enable the limitations described above to be overcome or at least attenuated.

According to the present invention, an integrated device and a method for manufacturing an integrated device are provided, as defined in claims 1 and 12, respectively.

### BRIEF DESCRIPTION OF THE DRAWINGS

For a better understanding of the invention, some embodiments thereof will now be described, purely by way of not limiting example and with reference to the attached drawings, wherein:
- Figure 1 is a cross-sectional view through an integrated device according to one embodiment of the present invention;
- Figure 2 shows an enlarged detail of the device of Figure 1;
- Figure 3 is a cross-sectional view through an integrated device according to a different embodiment of the present invention;
- Figure 4 is a cross-sectional view through an integrated device according to a further embodiment of the present invention;
- Figures 5-8 are cross-sectional views through a semiconductor wafer in successive steps of a method for manufacturing an integrated device according to an embodiment of the present invention;
- Figure 9 shows a cross-sectional view through a semiconductor wafer in a step of a method for manufacturing an integrated device according to a different embodiment of the present invention;
- Figures 10 and 11 show a cross-sectional view through a semiconductor wafer in successive steps of a method for manufacturing an integrated device according to a further embodiment of the present invention; and
- Figure 12 shows a cross-sectional view through a semiconductor wafer in a step of a method for manufacturing an integrated device according to a further embodiment of the present invention.

### DESCRIPTION OF EMBODIMENTS

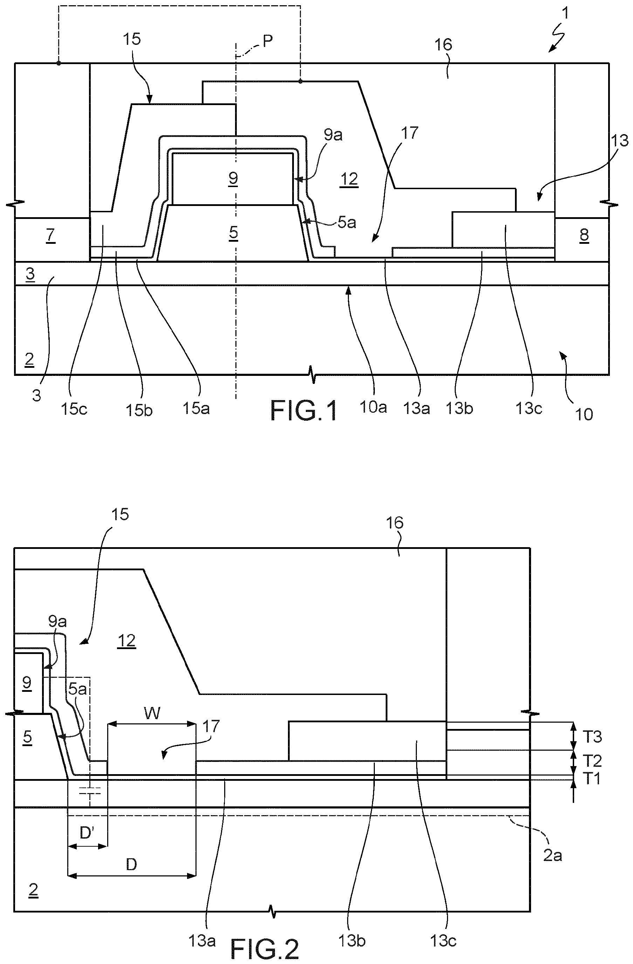

With reference to Figures 1 and 2, an integrated power device according to an embodiment of the present invention is designated as a whole by the number 1. For instance, the device 1 is an heterojunction integrated device of the normally-off type, in particular a HEMT (High-Electron-Mobility Transistor), and comprises a channel layer 2, a barrier layer 3, a gate region 5, a source contact 7, a drain contact 8, and a gate contact 9. The source contact 7 and the drain contact 8 may or may not be recessed with respect to the barrier layer 3.

The channel layer 2 and the barrier layer 3 are made of respective semiconductor materials with different bandgaps and form a heterostructure 10, with a heterojunction 10a at a common interface. For instance, the channel layer 2 is of intrinsic gallium nitride (GaN), whereas the barrier layer 3 is of aluminum and gallium nitride (AlGaN) and has a conductivity of an N type. A two-dimensional electron gas (2DEG) is formed in a channel region 2a of the channel layer 2 at the heterojunction 10, between the source contact 7 and the drain contact 8.

In addition to the channel layer 2 and the barrier layer 3, the integrated device 1 may comprise other layers belonging or connected to the heterostructure 10, amongst which, not necessarily and in a non-limiting way: a substrate having the function of mechanical support and/or electrical functions, for example of silicon or silicon carbide (SiC); a buffer layer between the substrate and the channel layer 2; a spacer layer, for example of aluminum nitride (AlN), between the channel layer 2 and the barrier layer 3; and a cap layer, for example of GaN, on the channel layer 3.

The gate region 5 is formed in contact with the barrier layer 3 between the source contact 7 and the drain contact 8 and, in one embodiment, is of the same material forming the channel layer 2 (GaN) doped so as to have a conductivity opposite to that of the barrier layer 3, in particular a conductivity of a P type in the example of Figure 1. The gate contact 9 extends over the gate region 5.

A source field plate 12 is connected (in a way not illustrated in Figure 1) to the source contact 7 and extends over the barrier layer 3 between the gate region 5 and the drain contact 8 and in part also over the gate region 5 and the gate contact 9. An insulating field structure 13 separates the source field plate 12 from the barrier layer 3 between the drain contact 8 and the gate region 5. An insulating gate structure 15 separates the source field plate 12 from the gate region 5 and from the gate contact 9, as well as from the barrier layer 3 between the source contact 7 and the gate region 5. A protective layer 16 of dielectric material, for example silicon oxide, coats the source field plate 12, the insulating field structure 13, and the insulating gate structure 15, and receives a source terminal 7a, a drain terminal 8a, and a gate terminal (not illustrated in Figure 1), which extend, respectively, as far as the source contact 7, the drain contact 8, and the gate contact 9.

The insulating field structure 13 has variable a thickness in the embodiment of Figure 1 increasing in stepwise fashion from the gate region 5 to the drain contact 8. In greater detail, the insulating field structure 13 comprises a first dielectric region 13a, a second dielectric region 13b, and a third dielectric region 13c, which are stacked on top of one another and extend to different extents from the drain contact 8 towards the gate region 5.

In one embodiment, the first dielectric region 13a, the second dielectric region 13b, and the third dielectric region 13c are portions of layers of a first dielectric material, a second dielectric material, and a third dielectric material, respectively, which are distinct from one another and each of which is selectively etchable with respect to the materials of the contiguous portions of the insulating field structure 13. In particular, the first dielectric region 13a, the second dielectric region 13b, and the third dielectric region 13c may be of aluminum oxide (Al₂O₃), silicon oxide, and silicon nitride, respectively.

The first dielectric region 13a extends over the barrier layer 3 from the gate contact 8 as far as the gate region 5, where it connects up to the insulating gate structure 15, and has a first thickness T1 not greater than 10 nm and for example comprised between 3 nm and 5 nm.

The second dielectric region 13b extends over the first dielectric region 13a from the gate contact 8, up to a distance D, to the gate region 5 in such a way that a window 17 having a width W is defined between the second dielectric region 13b and the insulating gate structure 15. For this reason the window 17 is occupied by a portion of the source field plate 12 that is in contact with the first dielectric region 13a. In one embodiment, the distance D is, for example, 300 nm and the width W is, for example, 100 nm. The distance D and the width W may be selected in such a way that the margin of the window 17 opposite to the second dielectric region 13b will be at a desired distance from the gate region 5 of generally less than 200 nm. For instance, with the values indicated above (D = 300 nm, W = 200 nm), the window 17 is arranged at 100 nm from the gate region 5.

The second dielectric region 13b has a second thickness T2 not greater than 100 nm and comprised, for example, between 30 nm and 50 nm. In one embodiment, the second thickness T2 is ten times greater than the first thickness T1.

The third dielectric region 13c extends over the second dielectric region 13b from the gate contact 8, is shorter than the second dielectric region 13b so as to form a step, and is in part coated by the source field plate 12. The third dielectric region 13b has a third thickness T3 not greater than 500 nm and comprised, for example, between 100 nm and 150 nm. In one embodiment, the third thickness T3 is three times greater than the second thickness T2.

The source field plate 12 consequently has three levels, corresponding to the first dielectric region 13a, the second dielectric region 13b, and the third dielectric region 13c, at respective distances T1, T1 + T2, and T1 + T2 + T3 from the surface of the barrier layer 3.

In one embodiment, the insulating gate structure 15 comprises a first portion 15a, a second portion 15b, and a third portion 15c, which may be parts of the same layers of which the first dielectric region 13a, the second dielectric region 13b, and the third dielectric region 13c, respectively, are made and are thus of the same materials and have the same thicknesses. In practice, a first layer that forms the first dielectric region 13a of the insulating field structure 13 and the first portion 15a of the insulating gate structure 15 extend continuously between the source contact 7 and the drain contact 8, coating the barrier layer 3, the gate region 5, and the gate contact 9 in a conformable way. A second layer forms the second dielectric region 13b of the insulating field structure 13 and the second portion 15b of the insulating gate structure 15, which coats the gate region 5 and the gate contact 9 in a conformable way and extends as far as the window 17, where the second layer is interrupted. The second portion 15b of the insulating gate structure 15 delimits the window 17 on the side towards the gate region 5.

A third layer forms the third dielectric region 13c of the insulating field structure 13 and the third portion 15c of the insulating gate structure 15, which extends from the source contact until it partially coats the gate region 5 and the gate contact 9. For instance, the third portion 15c of the insulating gate structure 15 extends as far as a median plane P of the gate region 5 and of the gate contact 9, perpendicular to the surface of the barrier layer 3.

Consequently, between the third portion 15c of the insulating gate structure 15 and the window 17 only the first portion 15a and the second portion 15b separate the source field plate 12 from the gate region 5 and from the gate contact 9. In addition, the thicknesses of the layers that form the first portion 15a and the second portion 15b of the insulating gate structure 15 cause also the source field plate 12 to extend along the sides 5a, 9a of the gate region 5 and of the gate contact 9 facing the drain contact 8. The distance of the source field plate 12 from the sides 5a, 9a of the gate region 5 and of the gate contact 9 is thus determined exclusively by the, substantially uniform, thicknesses of the layers that form the first portion 15a and the second portion 15b of the insulating gate structure 15.

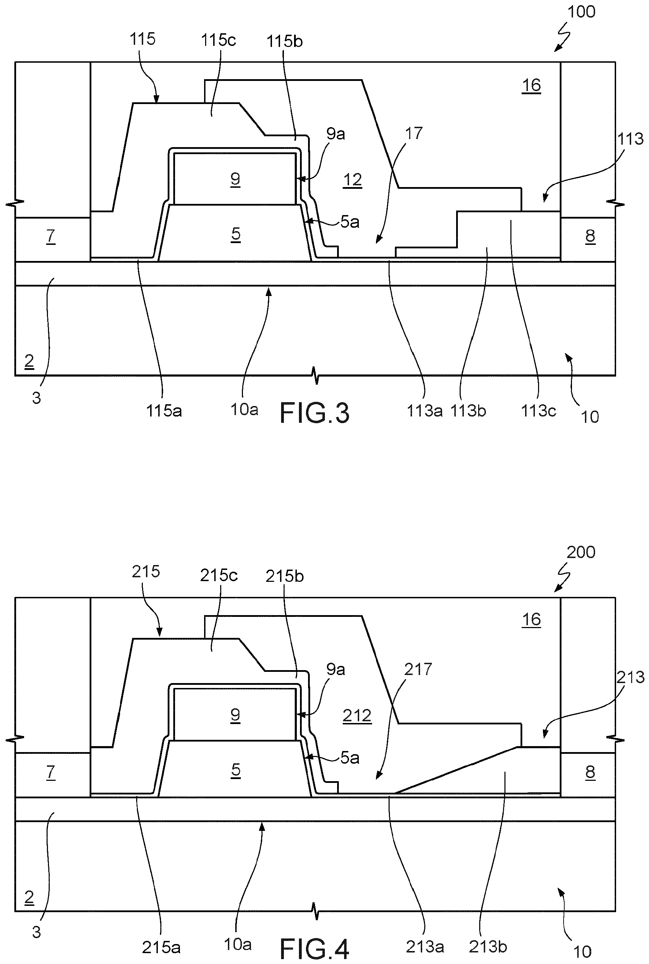

According to a different embodiment (illustrated in Figure 3), where parts that are the same as the ones already illustrated are designated by the same reference numbers, in an integrated device 100 an insulating field structure 113 and an insulating gate structure 115 have the same morphology and dimensions as the insulating field structure 13 and the insulating gate structure 15, respectively, of Figure 1. In this case, however, the first dielectric region 113a of the insulating field structure 113 is made of a first material, for example aluminum oxide, whereas the second region 113b and the third region 113c of the insulating field structure 113 are both made of a second material, selectively etchable with respect to the first material, for example silicon oxide or silicon nitride. Likewise, the first portion 115a of the insulating gate structure 115 is made of the first material, whereas the second portion 115b and the third portion 115c are both made of the same material.

The distance between the source field plate 12 and the sides 5a, 9a of the gate region 5 and of the gate contact 9 is determined exclusively by the residual thicknesses of the layers that form the first portion 115a and the second portion 115b of the insulating gate structure 115.

Figure 4 shows an integrated device 200 according to a different embodiment of the present invention. The integrated device 200 comprises the channel layer 2 and the barrier layer 3, which form: the heterostructure 10 and the heterojunction 10a; the gate region 5 with doping of a type opposite to that of the barrier layer 3; the source contact 7; the drain contact 8; and the gate contact 9. The integrated device 200 further comprises a source field plate 212, an insulating field structure 213, and an insulating gate structure 215. The insulating field structure 213 separates the source field plate 212 from the barrier layer 3 between the drain contact 8 and the gate region 5. The insulating gate structure 215 separates the source field plate 212 from the gate region 5 and from the gate contact 9, as well as from the barrier layer 3 between the source contact 7 and the gate region 5.

The insulating field structure 213 has a thickness that for a stretch is constant, in the proximity of the gate region 5, and for another stretch is variable in a ramp-wise fashion as far as the drain contact 8. In greater detail, the insulating field structure 213 comprises a first dielectric region 213a and a second dielectric region 213b.

The first dielectric region 213a extends over the barrier layer 3 from the gate contact 8 as far as the gate region 5, where it connects up to the insulating gate structure 215. The first dielectric region 213a is made of a first material, for example aluminum oxide, and has a first constant thickness T1 not greater than 10 nm, for example comprised between 3 nm and 5 nm.

The second dielectric region 213b is made of a second material, selectively etchable with respect to the material of the first dielectric region 213a and extends over the first dielectric region 213a forming an up-ramp that starts at a distance D from the gate region 5 and extends as far as the gate contact 8. A window 217 of width W is consequently defined between the insulating gate structure 215 and the start of the ramp of the second dielectric region 213b. The source field plate 212 thus contacts the first dielectric region 213a through the window 217. The distance D and the width W are, for example, 300 nm and 100 nm, respectively. At the end of the ramp, the second dielectric region 213b reaches a second maximum thickness T2' not greater than 100 nm and comprised, for example, between 30 nm and 50 nm. At this point, the thickness of the dielectric field region 213 is thus T1 + T2'.

The source field plate 212 has a level corresponding to the first dielectric region 213a and in contact therewith and an inclined surface matching the ramp formed by the second dielectric region 213b.

In one embodiment, the insulating gate structure 215 comprises a first portion 215a and a second portion 215b, which may be parts of the same layers from which the first dielectric region 213a and the second dielectric region 213b, respectively, are formed. In practice, a first layer that forms the first dielectric region 213a of the insulating field structure 213 and the first portion 215a of the insulating gate structure 215 extends continuously between the source contact 7 and the drain contact 8, coating the barrier layer 3, the gate region 5 and the gate contact 9. A second layer forms the second dielectric region 213b of the insulating field structure 213 and the second portion 215b of the insulating gate structure 215, which coats the gate region 5 and the gate contact 9 and extends as far as the window 17, where the second layer is interrupted. The second portion 215b of the insulating gate structure 215 delimits the window 17 on the side towards the gate region 5.

Also in this case, the distance of the source field plate 212 from the sides 5a, 9a of the gate region 5 and of the gate contact 9 is determined exclusively by the residual thicknesses of the layers that form the first portion 215a and the second portion 215b of the insulating gate structure 215.

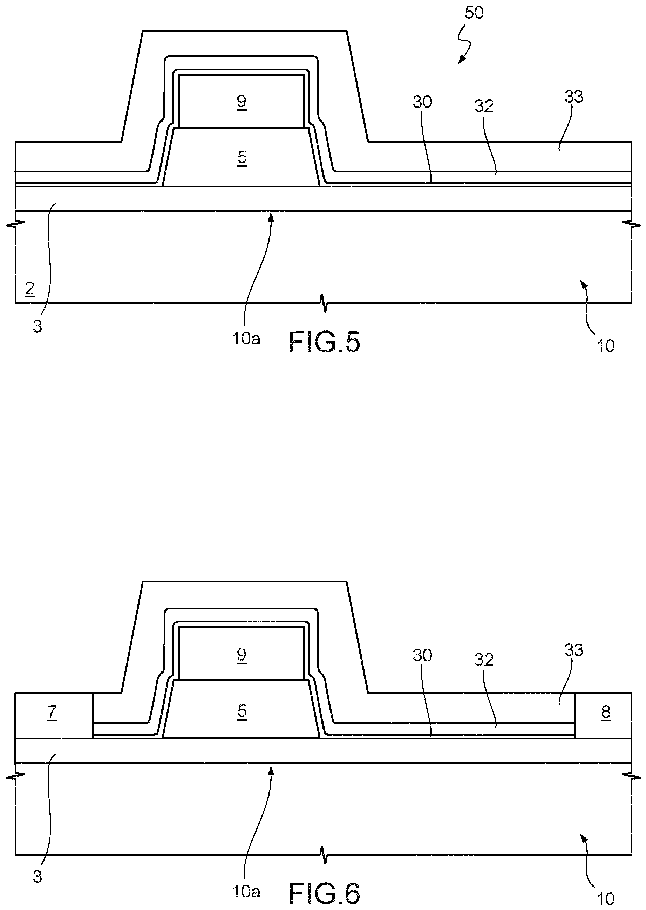

With reference to Figures 5-9, in a method for manufacturing the integrated device 1 according to an embodiment of the present invention, in a semiconductor wafer 50 the heterostructure 10 is initially made, and the gate region 5 and the gate contact 9 are formed on the heterostructure 10. Then, a first dielectric layer 30, a second dielectric layer 32, and a third dielectric layer 33 are laid in succession in order on the heterostructure 10 and on the gate region 5, coating both of these. Advantageously, the first dielectric layer 3a may be formed by ALD (Atomic-Layer Deposition), which makes it possible to control the thickness down to the individual atom.

The first dielectric layer 30 is made of the first material, for example aluminum oxide, and has the first thickness T1. The second dielectric layer 32 is made of the second material, for example silicon oxide, and has the second thickness T2. The third dielectric layer 33 is made of the third material, for example silicon nitride, and in one embodiment has a thickness that is less than the third thickness T3.

The first dielectric layer 30 defines the first dielectric region 13a of the insulating field structure 13 and the first portion 15a of the insulating gate structure 15.

Next (Figure 6), the source contact 7 and the drain contact 8 are formed. For this purpose, the first dielectric layer 30, the second dielectric layer 32, and the third dielectric layer 33 are etched using a same mask, and an operation of metal sputtering is carried out, followed by an annealing step.

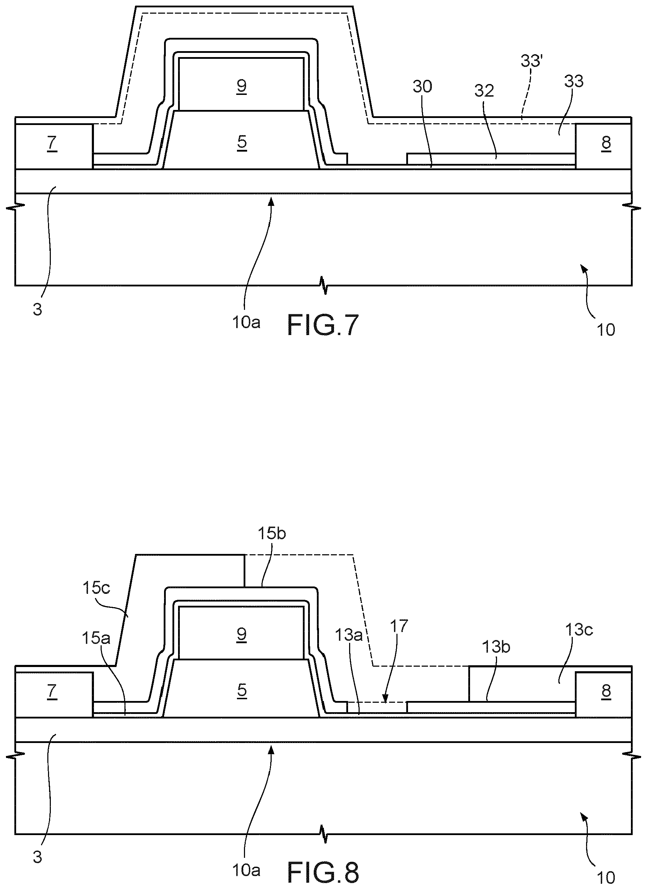

The third dielectric layer 33 is then increased as far as the third desired thickness T3, which is obtained with a further deposition of the third material. The increase of the third dielectric layer 33 due to the further deposition is designated by 33' in Figure 7. In this step, the source contact 7 and the drain contact 8 are coated so as to be kept separated from one another during subsequent formation of the source field plate 12.

The third dielectric layer 33 and the second dielectric layer 32 are then selectively etched in succession, in the order illustrated in Figure 8. For the etching operations respective masks are used, which are not illustrated for reasons of simplicity. The etches stop automatically on the underlying layers, given that the materials selected are selectively etchable. In particular, from the third dielectric layer 33 the third dielectric region 13c of the insulating field structure 13 and the third portion 15c of the insulating gate structure 15 are obtained. In the second dielectric layer 32 the window 17 is opened, thus separating the second dielectric region 13b of the insulating gate structure 13 from the second portion 15b of the insulating gate structure 15 and exposing the first dielectric region 13a.

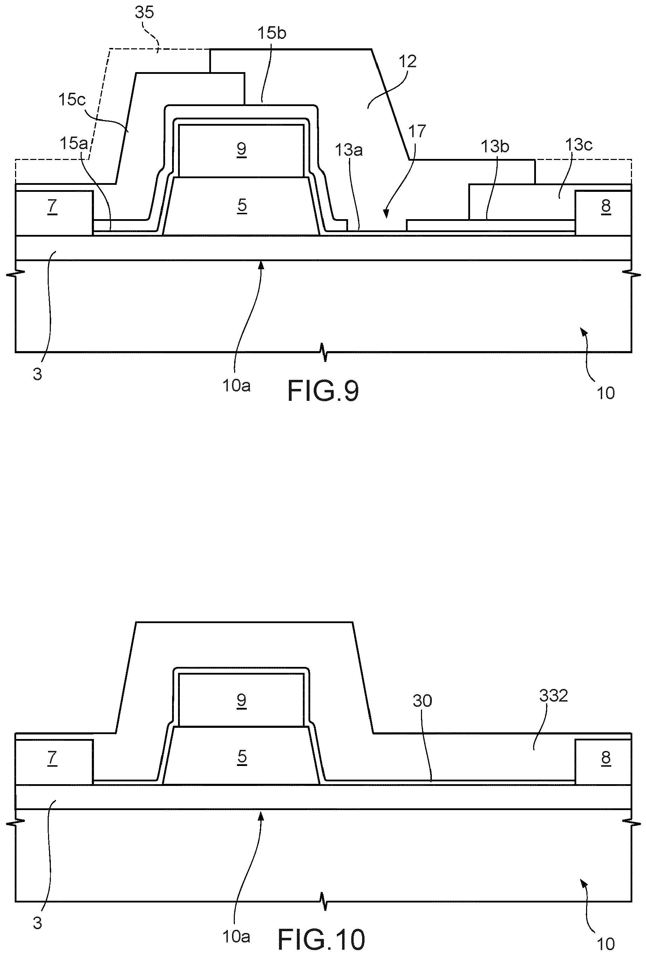

A metal layer 35 is then formed by metal evaporation and subsequently patterned using a further mask (not illustrated) to form the source field plate 12 (Figure 9). During this step, the source contact 7 and the gate contact 8 are coated and protected by a portion of the third dielectric layer 33 obtained during the deposition to enable increase to the third thickness T3.

Final machining steps are then carried out, amongst which the step of laying the protective layer 16 and the step of providing the source terminal 7a and the drain terminal 8a. The integrated device 1 of Figure 1 is thus obtained.

According to variants not illustrated of the method, the third dielectric layer 33 and the second dielectric layer 32 are selectively etched in succession, in that order, prior to formation of the source contact 7 and the drain contact 8, to define the insulating field structure 13 (third dielectric region 13c and second dielectric region 13b) and the insulating gate structure 15. In particular, according to one embodiment, after etching of the third dielectric layer 33 and the second dielectric layer 32, contact windows are opened for the source contact 7 and the drain contact 8, and a metal layer is laid by sputtering and subsequently defined to form simultaneously the source contact 7, the drain contact 8, and the field plate 13. Alternatively, first the metal layer is formed by sputtering, then contact windows are opened for the source contact 7 and the drain contact 8, and the metal layer is patterned to form the insulating field structure 13, and finally the source contact 7 and the drain contact 8 are formed by metal evaporation.

According to a different embodiment of the method according to the invention (Figure 10), the heterostructure 10 and the gate region 5 are initially formed. Then, the first dielectric layer 30 and a second dielectric layer 332, for example, of silicon oxide, are laid in succession in order on the heterostructure 10 and on the gate region 5, thus coating both. The first dielectric layer 30 and the second dielectric layer 332 are then patterned to open contact windows, where the source contact 7 and the drain contact 8 are formed. The second dielectric layer 332 may be brought to the final desired thickness by a further deposition of the second dielectric material, which also covers the source contact 7 and the drain contact 8.

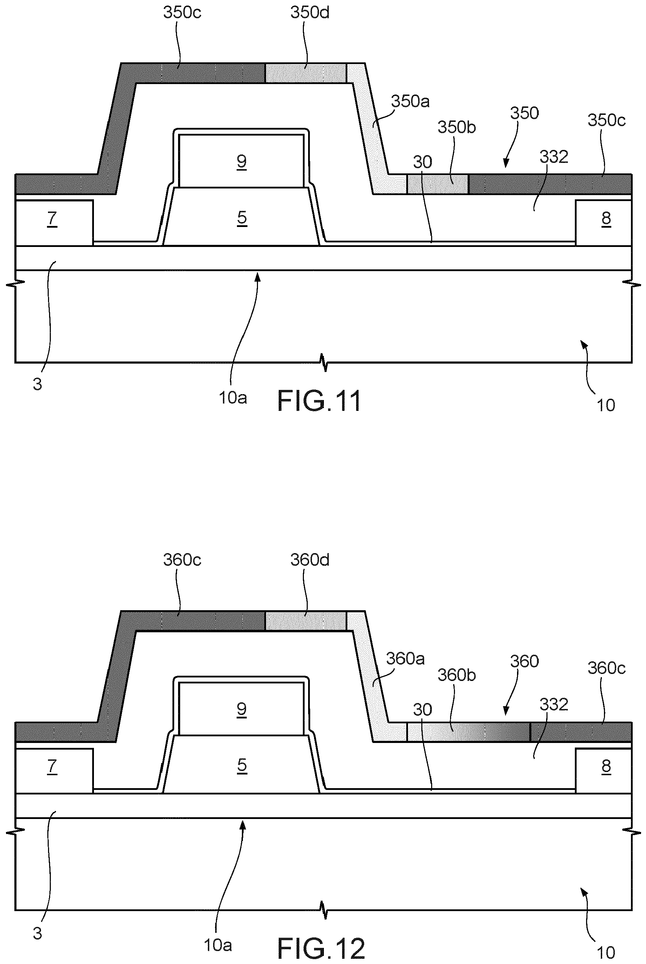

With reference to Figure 11, the second layer 332 is then defined to form the insulating field structure using a "greyscale" lithographic technique, which makes it possible to obtain differentiated densities of photoresist from a single layer (see, for example, Yu Pang, Yi Shu, Mohammad Shavetipur, Xuefeng Wang, Mohammad Ali Mohammad, Yi Yang, Haiming Zhao, Ningqin Deng, Roya Maboudian, and Tian-Ling Ren, "3D Stretchable Arch ribbon Array Fabricated via Grayscale Lithography", Scientific Reports, volume 6, Article number: 28552 (2016)). In practice, exploiting the diffraction through a mask with variable density and/or aperture widths, a photoresist layer is exposed and impressed in a differentiated way. In areas with higher densities and/or aperture widths, the photoresist is more exposed and a lower final density is obtained; instead, in areas with lower densities and/or aperture widths, the photoresist is exposed to a lesser extent, and a final higher density is obtained. In Figure 11 and in the subsequent Figure 12, the variable density of the photoresist layer is represented by different shades of grey: corresponding to regions with higher density is a darker shade of grey, and corresponding to regions with lower density is a lighter shade of grey.

Consequently, to obtain the integrated device 100 of Figure 3 it is possible to use a protective photoresist layer 350 (Figure 11) having a portion 350a with minimum density, a portion 350b with intermediate density, and a portion 350c with maximum density on the first dielectric region 113a, the second region 113b, and the third region 113c, respectively, of the insulating field structure 113.

Furthermore, a portion 350d of the protective photoresist layer 350, which has, for example, the same density as the portion 350b, extends in part over the gate contact 9 and in part over the sides 5a, 9a of the gate region 5 and of the gate contact 9, as far as the portion 350a (in practice, as far as the margin of the window 17). In this way, the second dielectric layer 332 is removed uniformly on the sides 5a, 9a as far as a residual thickness that depends upon the density of the portion 350d of the protective photoresist layer 350 and upon the etch time. Consequently, the distance of the source field plate 12 is determined exclusively by said residual thickness and by the thickness of the first dielectric layer 30, whereas it is not affected by the photolithographic limits for definition of the window 17.

To obtain, instead, the integrated device 200 of Figure 4 it is possible to use a protective photoresist layer 360 (Figure 12) having a portion 360a with minimum density, a portion 360b with linearly variable density, and a portion 360c with maximum density on the first dielectric region 213a and the second region 213b, respectively, of the insulating field structure 213. The density of the portion 360b varies between the minimum density of the portion 360a and the maximum density of the portion 360c.

Furthermore, a portion 360d of the protective photoresist layer 360 extends in part over the gate contact 5 and in part over the sides 5a, 9a of the gate region 5 and of the gate contact 9, as far as the portion 360a (in practice, as far as the margin of the window 217). In this way, the second dielectric layer 332 is removed uniformly on the sides 5a, 9a as far as a residual thickness that depends upon the density of the portion 360d of the protective photoresist layer 360 and upon the etch time. Consequently, the distance of the source field plate 12 is determined exclusively by said residual thickness and by the thickness of the first dielectric layer 30, whereas it is not affected by the photolithographic limits for definition of the window 217.

The invention advantageously enables improvement of the performance of integrated power devices, in particular of HEMTs of the normally -off type. More precisely, the use of materials that may be selectively etched with respect to one another for producing the insulating field structure enables control of the thickness of the first portion of the insulating field structure with a precision of the order of nanometres. The limit of precision is in fact determined by the processes of deposition with which it is possible to form layers having a thickness of even very few atoms. Etching of the overlying structures stops automatically owing to the selectivity of the materials, without any need for fine time control, and the thickness of the underlying layer, in particular of the first portion of the insulating field structure, is not involved. In this way, in the proximity of the gate region, the field plate may be reduced to just a few nanometres from the barrier layer, i.e., a distance equal to the thickness of just the first portion of the insulating field structure. This makes it possible to reduce drastically the gate-to-drain capacitance and, consequently, the accumulated charge, to the benefit of performance of the integrated device. As the distance from the gate region increases, the thickness of the insulating field structure may increase according to the design preferences so as to maintain the breakdown resistance. Also the profile of the insulating field structure may be chosen according to the design preferences, for example stepwise or rampwise. Advantageously, the thickness of the insulating field structure has at least an intermediate value between a minimum value in the proximity of the gate region and a maximum value at the drain terminal.

In addition, on the sides of the gate region and of the gate contact only the thicknesses of the first portion and of the second portion of the insulating gate structure separates the field plate from the gate region and the gate contact. The thickness of the first portion of the insulating gate region may be controlled even down to the individual atom by a process of atomic-layer deposition. The thickness of the second portion of the insulating gate structure is, however, controlled precisely through control of the deposition or etching parameters, and is not in any case conditioned by the limits of lithographic definition. Advantageously, also the distance of the field plate from the sides both of the gate region and of the gate contact can be controlled precisely and can be reduced considerably (for example, in the region of 40-60 nm). In turn, such a short distance of the field plate favours depletion of the gate region and contributes to reducing further and substantially the gate-to-drain capacitance, to the benefit of performance.

Finally, it is evident that modifications and variations may be made to the integrated device and to the method described herein, without thereby departing from the scope of the present invention, as defined in the annexed claims.

For instance, the insulating field structure may have a greater number of steps (four or more) according to the design preferences.

## Claims

1. An integrated power device comprising:
a heterostructure (10), including a channel layer (2) and a barrier layer (3), having a first type of conductivity;
a source contact (7), a drain contact (8), a semiconductive gate region (5), and a gate contact (9) on the gate region (5), wherein the gate region (5) has a second type of conductivity opposite to the first type of conductivity of the barrier layer (3) and is arranged on the barrier layer (3) between the source contact (7) and the drain contact (8);
an insulating gate structure (15; 115; 215), coating the gate region (5) and the gate contact (9) and comprising a first insulating gate portion (15a; 115a; 215a) and a second insulating gate portion (15b; 115b; 215b), which extend in a conformable way along sides (5a, 9a) of the gate region (5) and of the gate contact (9) that face the drain contact (8), wherein the first insulating gate portion (15a; 115a; 215a) coats, in contact therewith, the sides (5a, 9a) of the gate region (5) and of the gate contact (9), and the second insulating gate portion (15b; 115b; 215b) coats, in contact therewith, the first insulating gate portion (15a; 115a; 215a);
an insulating field structure (13) arranged on the barrier layer (3) between the gate region (5) and the drain contact (8); and a source field plate (12) on the insulating field structure (13) and electrically connected to the source contact (7),
wherein the insulating field structure (13; 113; 213) comprises a first dielectric region (13a; 113a; 213a) of a first dielectric material on the barrier layer (3) and a second dielectric region (13b; 113b; 213b) of a second dielectric material, selectively etchable with respect to the first dielectric material on the first dielectric region (13a; 113a; 213a);
wherein, on a side of the insulating field structure (13; 113; 213) towards the gate region (5), the source field plate (12) is in contact with the first dielectric region (13a; 113a; 213a) ; and wherein the source field plate extends in contact with the second insulating gate portion (15b; 115b; 215b) of the insulating gate structure (15; 115; 215) along the sides (5a, 9a) of the gate region (5) and of the gate contact (9) that face the drain contact (8).

2. The device according to claim 1, comprising an insulating gate structure (15) between the source field plate (12) and the gate region (5), wherein a window (17; 217) is defined between the insulating gate structure (15) and the second dielectric region (13b; 113b; 213b) and wherein the source field plate (12) is in contact with the first dielectric region (13a; 113a; 213a) in the window (17; 217).

3. The device according to claim 2, wherein the window (17) is arranged at a distance (D') from the gate region (5) of less than 200 nm and wherein the first dielectric region (13a; 113a; 213a) has a first thickness (T1) of less than 10 nm, for example comprised between 3 nm and 5 nm.

4. The device according to any one of the preceding claims, wherein the insulating field structure (13; 113; 213) has a minimum thickness, corresponding to the first thickness (T1) of the first dielectric region (13a; 113a; 213a), on the side of the insulating field structure (13; 113; 213) towards the gate region (5), a maximum thickness (T1 + T2 + T3; T1 + T2') on a side of the insulating field structure (13; 113; 213) towards the drain terminal (3), and an intermediate thickness (T1 + T2) between the side towards the gate region (5) and the side towards the drain terminal (3) of the insulating field structure (13; 113; 213).

5. The device according to claim 4, wherein the insulating field structure (13; 113) has a stepwise profile and comprises a third dielectric region (13c; 113c) on the second dielectric region (13b; 113b), wherein the second dielectric region (13b; 113b) has a second thickness (T2) not greater than 100 nm, for example comprised between 30 nm and 50 nm, and wherein the third dielectric region (13c; 113c) has a third thickness (T3) not greater than 500 nm, for example comprised between 100 nm and 150 nm.

6. The device according to any one of claims 1 to 4, wherein the second dielectric region (213b) of the insulating field structure (213) has a rampwise profile.

7. The device according to any one of the preceding claims, wherein the first insulating gate portion (15a; 115a; 215a) and the second insulating gate portion (15b; 115b; 215b) of the insulating gate structure (15; 115; 215) have respective uniform thicknesses.

8. The device according to claim 7, wherein a distance of the source field plate (12) from the sides (5a, 9a) of the gate region (5) and of the gate contact (9) that faces the gate contact (8) is determined exclusively by the thicknesses of the first insulating gate portion (15a; 115a; 215a) and of the second insulating gate portion (15b; 115b; 215b) of the insulating gate structure (15; 115; 215).

9. A method for manufacturing an integrated power device, comprising:
forming a heterostructure (10), including a channel layer (2) and a barrier layer (3), having a first type of conductivity;
on the barrier layer (3), forming a source contact (7), a drain contact (8), and a gate region (5), having a second type of conductivity opposite to the first type of conductivity of the barrier layer (3), between the source contact (7) and the drain contact (8);
forming a gate contact (9) on the gate region (5);
from the first dielectric layer (30) and the second dielectric layer (32; 332), forming an insulating gate structure (15; 115; 215), which coats the gate region (5) and the gate contact (9), and an insulating field structure (13) on the barrier layer (3) between the gate region (5) and the drain contact; and
on the insulating field structure (13) and on the insulating gate structure (15; 115; 215), forming a source field plate (12) electrically connected to the source contact (7);
wherein forming the insulating field structure (13; 113; 213) and the insulating gate structure (15; 115; 215) comprises:
forming a first dielectric layer (30) of a first dielectric material on the barrier layer (3), on the gate region (5), and on the gate contact (9); and
forming a second dielectric layer (32; 332) of a second dielectric material, selectively etchable with respect to the first dielectric material on the first dielectric layer (30);
wherein forming the insulating field structure (13; 113; 213) comprises selectively etching the second dielectric layer (32; 332) on a side of the insulating field structure (13; 113; 213) towards the gate region (5) so as to expose a portion of the first dielectric layer (30) at the gate region (5);
wherein the source field plate (12) is in contact with the first dielectric region (13a; 113a; 213a) where the first dielectric region (13a; 113a; 213a) has been exposed;
wherein portions of the first dielectric layer (30) and of the second dielectric layer (32; 332) that extend in a conformable way along sides (5a, 9a) of the gate region (5) and of the gate contact (9) facing the drain contact (8) form, respectively, a first insulating gate portion (15a; 115a; 215a) and a second insulating gate portion (15b; 115b; 215b) of the insulating gate structure (15; 115; 215), wherein the first insulating gate portion (15a; 115a; 215a) coats, in contact therewith, the sides (5a, 9a) of the gate region (5) and of the gate contact (9), and wherein the second insulating gate portion (15b; 115b; 215b) coats, in contact therewith, the first insulating gate portion (15a; 115a; 215a);
and wherein the source field plate (12) extends in contact with the second insulating gate portion (15b; 115b; 215b) of the insulating gate structure (15; 115; 215) along the sides (5a, 9a) of the gate region (5) and of the gate contact (9) facing the drain contact (8).

10. The method according to claim 9, wherein selectively etching comprises defining a window (17; 217) between the insulating gate structure (15) and the second dielectric region (13b; 113b; 213b) and wherein the source field plate (12) is in contact with the first dielectric region (13a; 113a; 213a) in the window (17; 217) .

11. The method according to claim 10, wherein forming the insulating field structure (13) comprises:
forming a third dielectric layer (33) of a third dielectric material, selectively etchable with respect to the second dielectric material on the second dielectric layer (13b); and
selectively etching the third dielectric material (33) so as to expose the second dielectric layer (32) between the window (17; 217) and the drain contact (8) and define a stepwise profile of the insulating field structure (13).

12. The method according to claim 11, wherein form the insulating field structure (113; 213) comprises patterning the second layer (332) with a greyscale lithographic technique so as to define a stepwise or rampwise profile of the insulating field structure (113; 213).

13. The method according to any one of claims 9 to 12, wherein the first dielectric layer (30) is formed by atomic-layer deposition.

14. The method according to any one of claims 9 to 13, wherein forming the insulating field structure (13) and the insulating gate structure (15) comprises depositing a third dielectric layer (33) of a third dielectric material selectively etchable with respect to the second dielectric material, and removing the third dielectric layer (33) on the insulating gate structure (15) .

15. The method according to any one of claims 9 to 13, wherein forming the insulating gate structure (15) comprises removing the second dielectric layer (332) uniformly on the sides (5a, 9a) of the gate region (5) and of the gate contact (9) down to a residual thickness.
